# DEMANDE DE BREVET EUROPEEN

(11) **EP 2 743 976 A1**
(43) Date de publication de la demande: **18.06.2014**
(21) Numéro de dépôt: 13196969.3
(22) Date de dépôt: 12.12.2013
(51) Int. Cl.: H01L 21/762

(54) **Procédé de fabrication d'une plaquette semiconductrice hybride SOI/massif**

(30) Priorité: 13.12.2012 FR 1262012
(71) Demandeur: STmicroelectronics SA, 92120 Montrouge (FR); STMicroelectronics (Crolles 2) SAS, 38920 Crolles (FR); STMicroelectronics, Inc., Coppell, TX 75019 (US); COMMISSARIAT A L'ENERGIE ATOMIQUE ET AUX ENERGIES ALTERNATIVES, 75015 Paris (FR)
(72) Inventeur: Fenouillet-Beranger, Claire, 38500 Grenoble (FR); Denorme, Stéphane, 38920 CROLLES (FR); Loubet, Nicolas, GUILDERLAND, NY New York 12084 (US); Liu, Qing, GUILDERLAND, NY New York 12084 (US); Richard, Emmanuel, 38190 LE CHAMP-PRES-FROGES (FR); Perreau, Pierre, 75015 PARIS (FR)
(74) Mandataire: Thibon, Laurent

(57) **Abrégé**

L'invention concerne un procédé de fabrication d'un substrat hybride SOI/massif, comprenant les étapes suivantes :
a) partir d'une plaquette SOI comprenant une couche semiconductrice monocristalline appelée couche SOI (3), sur une couche isolante (2), sur un substrat semiconducteur monocristallin (1) ;
b) déposer sur la couche SOI au moins une couche de masquage (17, 18) et former des ouvertures traversant la couche de masquage, la couche SOI et la couche isolante jusqu'à atteindre le substrat ;
c) faire croître par une alternance répétée d'étapes d'épitaxie sélective et de gravure partielle un matériau semiconducteur (27) ; et
d) graver des tranchées d'isolement entourant lesdites ouvertures remplies de matériau semiconducteur, en empiétant vers l'intérieur sur la périphérie des ouvertures.

## Description

### Domaine technique

La présente invention concerne un procédé de fabrication, sur une même plaquette semiconductrice, de zones de type SOI ("Semiconductor-On-Insulator" - silicium-sur-isolant), et de zones de substrat massif (substrat bulk).

### Exposé de l'art antérieur

Pour améliorer les performances des transistors MOS assurant les fonctions logiques d'un circuit intégré et pour réduire leurs dimensions, une solution consiste à fabriquer ces transistors MOS dans et sur une couche semiconductrice monocristalline mince formée sur une couche isolante reposant sur un substrat semiconducteur monocristallin. La couche semiconductrice monocristalline mince est alors couramment désignée dans la technique par les termes "couche SOI". On appellera substrat ou plaquette SOI un substrat ou une plaquette semiconductrice revêtu d'une telle couche SOI.

Avec les progrès de la technologie, on tend à diminuer de plus en plus les dimensions minimales des transistors dont la longueur de grille peut être inférieure à 20 nm et l'épaisseur de la couche SOI est corrélativement réduite à des valeurs inférieures à 10 nm, et même à des valeurs inférieures à 5 nm. Des couches SOI aussi minces ne conviennent pas à la formation de composants aptes à supporter des tensions plus élevées que les tensions des composants logiques et/ou à laisser passer des courants plus élevés que ceux impliqués dans le fonctionnement des composants logiques, ce qui est par exemple le cas de dispositifs de protection contre des décharges électrostatiques. Il est souhaitable de former ces derniers composants, appelés ici "composants de puissance" pour les différentier des composants logiques, directement dans un substrat semiconducteur monocristallin.

On cherche donc à former une plaquette mixte ou hybride comportant des zones de type SOI adaptées à la formation de composants logiques, et des zones de substrat massif adaptées à la formation de composants de puissance. Il convient en outre pour la formation de composants dans et sur les zones de type SOI et dans et sur les zones de substrat massif que les surfaces supérieures de ces zones soient aussi exactement que possible dans un même plan, ce qui permet notamment la réalisation d'étapes de photolithographie optimisées.

Les procédés connus de formation d'une telle plaquette hybride tels que celui décrit dans le brevet des États-Unis d'Amérique N° 5 894 152 présentent divers inconvénients. Ils sont délicats à mettre en oeuvre, impliquent un grand nombre d'étapes, et/ou ne sont pas adaptés au cas où l'épaisseur de la couche SOI a une valeur inférieure à 10 nm, voire inférieure à 5 nm.

### Résumé

Ainsi, on prévoit ici un procédé de fabrication d'un substrat hybride SOI/massif, comprenant les étapes suivantes :
a) partir d'une plaquette SOI comprenant une couche semiconductrice monocristalline appelée couche SOI, sur une couche isolante, sur un substrat semiconducteur monocristallin ;
b) déposer sur la couche SOI au moins une couche de masquage et former des ouvertures traversant la couche de masquage, la couche SOI et la couche isolante jusqu'à atteindre le substrat ;
c) faire croître par une alternance répétée d'étapes d'épitaxie sélective et de gravure partielle un matériau semiconducteur ; et
d) graver des tranchées d'isolement entourant lesdites ouvertures remplies de matériau semiconducteur, en empiétant vers l'intérieur sur la périphérie des ouvertures.

Selon un mode de réalisation, l'étape c) est poursuivie jusqu'à ce que la partie centrale de la surface supérieure du matériau semiconducteur soit au même niveau que la surface supérieure de la couche SOI.

Selon un mode de réalisation, le matériau semiconducteur du substrat et celui de la couche SOI sont du silicium.

Selon un mode de réalisation, l'épaisseur de la couche SOI est comprise entre 3 et 10 nm.

Selon un mode de réalisation, l'épaisseur de la couche isolante est comprise entre 5 et 50 nm.

Selon un mode de réalisation, la couche de masquage comprend un empilement d'une couche d'un oxyde de silicium et d'une couche d'un nitrure de silicium.

Selon un mode de réalisation, le procédé comprend en outre, entre les étapes a) et b), une étape consistant à former des régions de silicium-germanium dans des portions de la couche SOI.

Selon un mode de réalisation, les régions de silicium-germanium sont formées par condensation.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
les figures 1A et 1B sont des vues en coupe illustrant de façon schématique respectivement un substrat SOI et un substrat massif ;
la figure 2 est une vue en coupe illustrant de façon schématique un substrat hybride SOI/massif ;
les figures 3A à 3D sont des vues en coupe illustrant de façon schématique des étapes successives d'un mode de réalisation d'une première phase d'un procédé de fabrication d'un substrat hybride SOI/massif ; et
les figures 4A à 4C sont des vues en coupe illustrant de façon schématique des étapes successives d'un mode de réalisation d'une deuxième phase d'un procédé de fabrication d'un substrat hybride SOI/massif.

Par souci de clarté, de mêmes éléments ont été désignés par de mêmes références dans les différentes figures. De plus, comme cela est habituel dans la représentation des circuits intégrés, les diverses figures ne sont pas tracées à l'échelle.

### Description détaillée

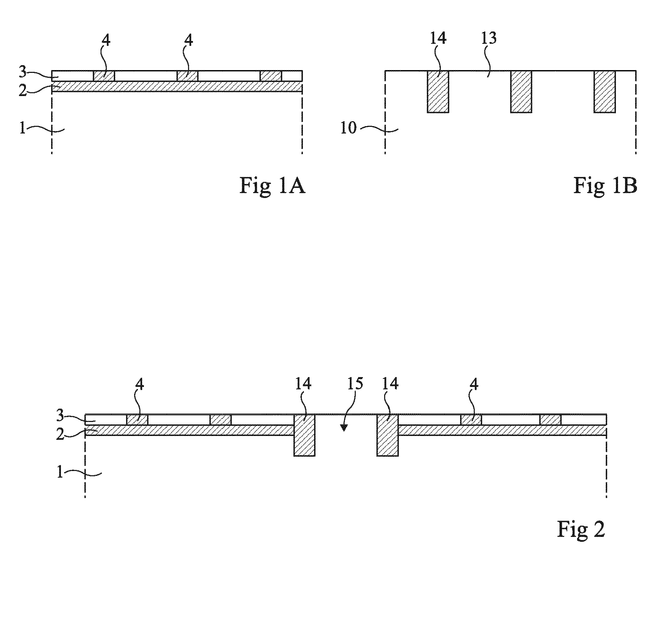

On rappellera en relation avec les figures 1A et 1B ce qu'on appelle classiquement un substrat SOI et un substrat massif (bulk).

La figure 1A est une vue en coupe schématique d'une portion d'une plaquette SOI. Cette plaquette est formée à partir d'un substrat semiconducteur 1, généralement un substrat semiconducteur monocristallin, sur lequel repose une couche mince isolante 2, couramment appelée couche BOX, sur laquelle repose une couche mince 3 d'un semiconducteur monocristallin, couramment appelée couche SOI.

La couche semiconductrice mince 3 est divisée en zones actives dans chacune desquelles sont susceptibles d'être formés un ou plusieurs composants, couramment un unique transistor MOS. Ces zones actives sont séparées par des régions isolantes 4 qui en vue de dessus, entourent chacune des zones actives. Ainsi, dans une plaquette SOI, chacun des composants formés dans une zone active est complètement isolé des composants voisins par la couche isolante 2 et par les régions isolantes 4.

Une plaquette dite de semiconducteur massif, tel qu'illustrée en figure 1B, est constituée d'une plaquette en un matériau semiconducteur monocristallin 10 à la surface de laquelle sont éventuellement développées une ou plusieurs couches épitaxiées. La partie supérieure de la plaquette est divisée en zones actives 13 par des tranchées isolantes 14. Des composants sont formés dans les zones actives. Les tranchées isolantes doivent être relativement profondes pour assurer un isolement relatif entre les composants voisins. Cet isolement est en outre assuré par des couches enterrées de niveaux de dopage appropriés destinées à limiter les courants de fuite entre composants voisins. Les tranchées isolantes 14 sont souvent désignées par les sigles STI, de l'anglais Shallow Trench Isolation (isolement par tranchées peu profondes) ou DTI de l'anglais Deep Trench Isolation (isolement par tranchées profondes). Bien entendu, cette notion de tranchée profonde ou de tranchée peu profonde dépend de la technologie utilisée et de la profondeur dont les zones dopées de chacun des composants formé dans les zones actives pénètrent dans le substrat.

Comme on l'a indiqué précédemment, chacune des technologies sur substrat SOI et sur substrat massif présente ses intérêts propres et il est parfois souhaitable de disposer sur une même plaquette semiconductrice de régions dans lesquelles on peut former des composants dans une couche SOI et des composants dans un substrat massif. Ainsi, on cherche à obtenir des plaquettes hybrides comprenant des régions de substrat SOI et des régions de substrat massif.

En figure 2, on a représenté sur un substrat semiconducteur 1, une couche isolante 2 et une couche SOI 3 munie de ses régions d'isolement 4. Au centre de la figure, on a représenté une région où le substrat semiconducteur remonte jusqu'à la surface et est séparé des composants voisins par des tranchées d'isolement STI ou DTI 14. Les tranchées 14 entourent une zone active 15 dans laquelle on peut former un composant.

Dans ce qui suit, pour simplifier la description, on considère le cas particulier dans lequel le matériau du substrat massif et celui de la couche SOI sont tous deux du silicium monocristallin mais cela ne constitue qu'un exemple de matériaux semiconducteurs possibles.

Pour obtenir une plaquette hybride du type de celle de la figure 2, on a proposé, par exemple dans le brevet des États-Unis d'Amérique N° 5 894 152 susmentionné, de partir d'une plaquette de type SOI, de former une ouverture traversant la couche SOI et la couche isolante sous-jacente jusqu'à atteindre le substrat, puis de procéder à une épitaxie de silicium à partir du fond du substrat découvert. Ce procédé pose de nombreux problèmes parmi lesquels on peut mentionner les suivants.

D'une part, si, comme le propose essentiellement le brevet susmentionné, on procède à une épitaxie non sélective de silicium, du silicium se dépose partout et il faut ensuite l'enlever par un procédé de polissage physico-chimique, couramment désigné par le sigle CMP, de l'anglais Chemical Mechanical Polishing (polissage mécano-chimique). Un tel polissage physico-chimique entraîne de nombreux problèmes de réalisation, notamment quand on veut s'arrêter avec précision à la hauteur de la couche SOI pour que la surface supérieure de la partie de substrat massif soit au même niveau que la surface supérieure de la couche SOI. En effet, quand la couche SOI est très mince, d'une épaisseur inférieure à 20 nm, voire de 5 nm, un polissage mécano-chimique risque de la dégrader.

D'autre part, la mise en oeuvre de ce procédé implique de revêtir les bords de l'ouverture d'une couche de protection telle qu'une couche de nitrure de silicium puis de dégager le fond de cette couche. Ceci nécessite des étapes supplémentaires dont certaines, notamment d'élimination du fond de la couche, sont relativement délicates.

On a également tenté de procéder à des épitaxies sélectives à partir du fond de l'ouverture, les bords de l'ouverture étant protégés par une couche de nitrure de silicium avec les inconvénients mentionnés précédemment. De plus, il s'avère que, de façon générale, quand on procède à une épitaxie sélective, le silicium déposé par épitaxie ne se développe pas de façon uniforme, mais, du fait de sa cristallinité, se développe en formant des facettes. Le silicium croît donc plus rapidement dans certaines directions que dans d'autres et, à nouveau, il s'avère nécessaire de procéder à une étape de polissage physico-chimique pour aplanir la surface supérieure de la couche épitaxiée, ce qui entraîne des inconvénients susmentionnés.

Il a été décrit, par exemple dans l'article de Nicolas Loubet et al. présenté à la conférence SSDM, Tokyo, 22-24 septembre 2010, de procéder à une épitaxie sélective en évitant le problème de facettage du silicium. Pour cela, on procède à des étapes successives de dépôt épitaxial d'une couche de silicium très mince puis de gravure de cette couche et on répète plusieurs fois ce processus jusqu'à atteindre la hauteur souhaitée. Cet article indique que, à condition de contrôler avec une grande précision la température de croissance épitaxiale, la composition des précurseurs et les temps de croissance et de gravure, on peut arriver à surélever les régions de drain et de source d'un transistor MOS par une croissance épitaxiale plane, non facettée. Néanmoins, à nouveau, pour mettre en oeuvre ce processus, cet article prévoit que les bords de l'ouverture à partir du fond de laquelle est réalisée la croissance épitaxiale sont revêtus d'un matériau spécifique, en l'espèce du nitrure de silicium. On retrouve donc l'inconvénient mentionné précédemment de devoir revêtir d'abord des ouvertures de nitrure de silicium puis d'éliminer le nitrure de silicium du fond de l'ouverture.

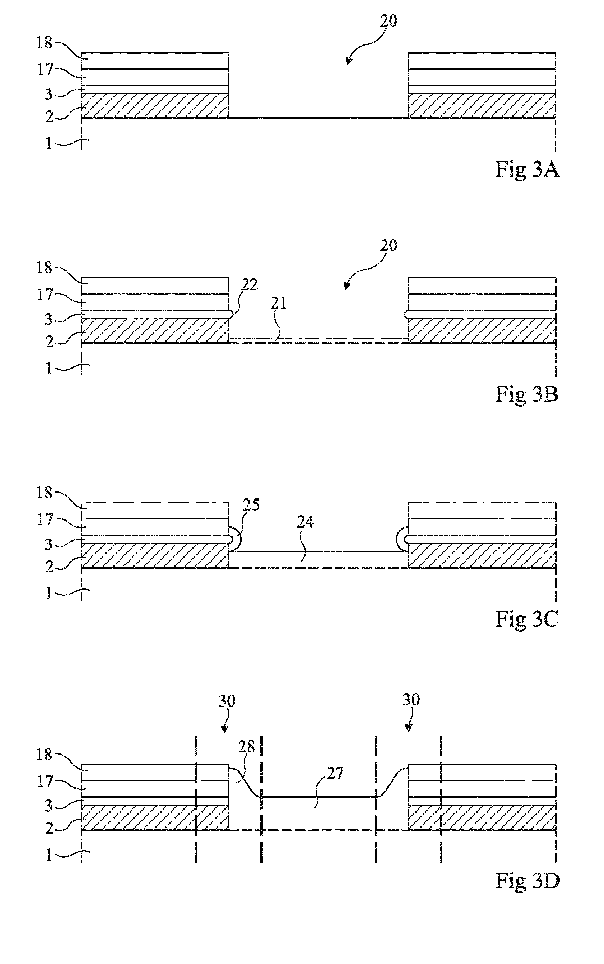

Les figures 3A à 3D décrivent des étapes successives d'obtention par épitaxie d'une couche de silicium à fond plat dans une ouverture formée à travers une structure SOI, les flancs de cette ouverture n'étant pas revêtus d'une couche de protection telle que du nitrure de silicium.

La figure 3A représente une plaquette SOI comprenant, comme en figure 2, un substrat 1 de silicium monocristallin revêtu d'une couche isolante (BOX) 2 et d'une couche SOI de silicium monocristallin 3. Cette plaquette SOI est revêtue d'une couche de masquage, composée par exemple d'une première couche d'oxyde de silicium 17 et d'une deuxième couche de nitrure de silicium 18, constituant un masque dur. On forme une ouverture 20 dans cet ensemble, jusqu'à atteindre la surface supérieure du silicium du substrat 1.

Ensuite, on procède à des étapes alternées et répétées de croissance épitaxiale sélective de silicium et de gravure partielle.

La figure 3B illustre l'allure du dépôt obtenu après une première étape de croissance et de gravure. La croissance sélective ne se produit qu'à partir des surfaces apparentes de silicium : une couche sensiblement plane de silicium 21 est formée sur le substrat 1 au fond de l'ouverture 20 et une légère excroissance de silicium 22 est formée en anneau à partir du flanc exposé de la couche SOI 3. Si on se place dans les conditions de l'article susmentionné de Nicolas Loubet, la face supérieure de la couche de silicium 21 est sensiblement plane.

La figure 3C représente l'allure du dépôt obtenu après un certain nombre de cycles de dépôt par épitaxie et de gravure. On a obtenu, au fond de l'ouverture une couche 24 sensiblement plane et une excroissance 25 formée à partir du flanc exposé de la couche SOI 3.

Après un certain nombre de répétitions des cycles de dépôt épitaxial et de gravure, on arrive à la structure illustrée en figure 3D. La surface supérieure du silicium déposé, 27, est en forme de cuvette à fond plat, et comprend un rebord (une protubérance) 28 périphérique lié à la croissance à partir du flanc exposé de la couche SOI 3. En raison du caractère itératif des opérations d'épitaxie et de gravure, l'épaisseur du dépôt peut être très bien calibrée pour que la surface supérieure du fond de la cuvette soit exactement au niveau de la surface supérieure de la couche SOI 3.

Ensuite, une fois cette structure obtenue, on creuse par tout moyen des tranchées d'isolement (STI ou DTI) à la périphérie de la cuvette 27, pour éliminer la protubérance périphérique 28. On a indiqué par des pointillés gras verticaux en figure 3D, les limites entre lesquelles on va creuser une tranchée d'isolement périphérique 30.

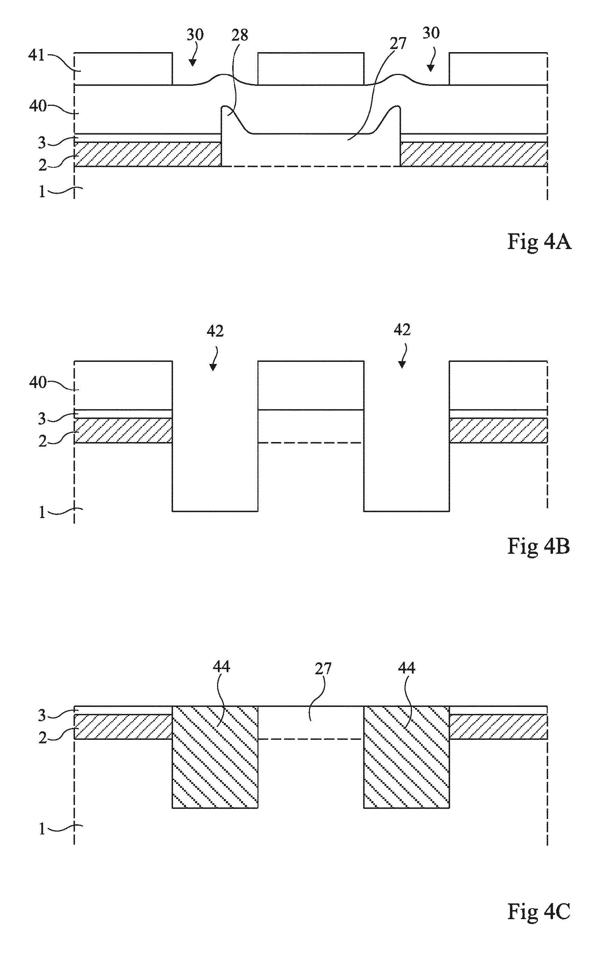

Les figures 4A à 4C illustrent un exemple de réalisation des tranchées d'isolement. D'autres modes de réalisation de ces tranchées pourront être utilisés. L'important est que ces tranchées soient réalisées à la périphérie de la couche déposée par épitaxie, et éliminent les protubérances latérales 28 de la couche 27.

A l'étape illustrée en figure 4A, on retrouve la structure de la figure 3D comprenant le substrat 1, la structure SOI 2-3, et le remplissage épitaxial 27 à face supérieure en forme de cuvette dont le fond plat est au même niveau que la surface supérieure de la couche SOI 3, cette cuvette comprenant une protubérance périphérique 28. La couche de masquage 17-18 a été éliminée par gravure sélective. Une nouvelle couche de masquage-protection 40 a été déposée. La couche de masquage-protection 40 est déposée selon une épaisseur suffisante, ou selon un procédé adapté, pour lisser sa surface supérieure. Ainsi, si la surface supérieure de la couche 40 comprend une surépaisseur en regard de la protubérance périphérique 28, cette surépaisseur est moindre que la hauteur de la protubérance 28. La couche 40 est par exemple constituée d'un sandwich d'une couche d'oxyde de silicium de 5 nm et d'une couche de nitrure de silicium de 50 à 70 nm d'épaisseur.

Sur la couche 40 est déposée une couche de photo-lithogravure 41, couramment une couche de résine, qui comprend une ouverture 30 en regard de la protubérance périphérique 28 de la couche épitaxiale de remplissage 27, l'ouverture 30 s'étendant de part et d'autre de la protubérance 38.

A l'étape illustrée en figure 4B, on a représenté le creusement de tranchées d'isolement 42 qui pénètrent jusqu'à l'intérieur du substrat 1. En raison du choix du positionnement des ouvertures 30 dans la couche de masquage 41, en partie en regard d'une zone SOI du substrat et en partie en regard d'une zone massive épitaxiée, il reste seulement la partie centrale de la couche 27 dont la surface supérieure est plane et au même niveau que la surface supérieure de la couche SOI 3.

A l'étape illustrée en figure 4C, on a procédé au remplissage des tranchées d'isolement par un matériau approprié 44, couramment de l'oxyde de silicium et à l'élimination de la couche de protection 40.

On notera que l'ensemble du procédé de formation d'un substrat hybride SOI/massif, comprenant des étapes telles que celles décrites en relation avec les figures 3A à 3D et des étapes telles que celles décrites en relation avec les figures 4A à 4C, présente de nombreux avantages.
- On obtient une surface supérieure plane d'une couche épitaxiale développée à partir du substrat, cette surface supérieure plane pouvant être au même niveau que la face supérieure d'une couche SOI.
- Ce résultat est obtenu sans qu'il ait été nécessaire de prévoir d'étape de polissage (CMP).
- Ce résultat est obtenu sans qu'il ait été nécessaire de prévoir une couche de protection telle qu'une couche de nitrure de silicium sur les flancs d'une ouverture formée dans une couche SOI et une couche isolante sous-jacente.
- Ce résultat est obtenu grâce au fait que l'on s'est affranchi du préjugé selon lequel il fallait réaliser une croissance épitaxiale sélective totalement plane. Au contraire, dans le procédé décrit ici, la couche épitaxiale développée présente une protubérance périphérique mais qui est sans inconvénient puisqu'elle est éliminée ensuite lors de la formation de tranchées d'isolement.

Bien entendu, la présente invention est susceptible de nombreuses variantes et modifications notamment en ce qui concerne les détails des étapes de procédé et le choix des matériaux utilisés.

Le procédé a été décrit dans le cas où le substrat 1 est un substrat de silicium monocristallin, la couche SOI est également une couche de silicium monocristallin et la couche de remplissage épitaxiale est également une couche de silicium monocristallin. Toutefois, le procédé n'est pas limité à ce cas particulier. D'autres semiconducteurs pourraient être utilisés. Notamment, la croissance épitaxiale pourrait être une croissance d'un semiconducteur mixte tel que du silicium-germanium. De même, la couche SOI pourrait être une couche de silicium-germanium ou d'un autre semiconducteur. En outre, dans le cas où le semiconducteur décrit ci-dessus est du silicium, on pourra transformer, avant la première étape de la figure 3A, une partie de la couche SOI 3 en silicium-germanium, par exemple par des procédés de condensation. Il est possible de le faire à une étape initiale du procédé car le mode de croissance épitaxiale décrit ici est un mode de croissance à basse température qui ne dégradera pas la couche de silicium-germanium formée par condensation.

A titre d'exemple de valeurs numériques, dans le cas d'une technologie dans laquelle la longueur de grille des transistors qui seront formés dans la couche SOI est de l'ordre de 20 nanomètres, les diverses couches peuvent avoir les épaisseurs suivantes :
- couche isolante 2 (BOX) : 5 à 50 nm,
- couche SOI 3 : 3 à 10 nm,
- couche 40 : 50 à 80 nm
   et les dimensions suivantes pourront être choisies :
- dimension minimum des zones actives dans la couche SOI : par exemple de l'ordre de 70 x 70 nm,
- largeur minimum finale des régions 27 obtenue en fin de procédé (étape de la figure 4C) : de l'ordre de 0,12 µm,
- largeur des tranchées d'isolement 42 : de l'ordre de 42 nm,
- profondeur de pénétration des tranchées d'isolement 42 dans le substrat : de 0 à 50 nm.

Dans la présente description, sauf indication contraire, les termes "sensiblement" et "de l'ordre de" signifient "à 10 % près".

Les exemples numériques ci-dessus ont été donnés dans le cas particulier d'une technologie où la longueur de grille de transistors MOS logiques est de l'ordre de 20 nm. Ces dimensions seront adaptées à la technologie utilisée, et seront plus faibles dans le cas d'une technologie où la longueur de grille est inférieure à 20 nm.

Par ailleurs, on comprendra que l'on a décrit précédemment une zone particulière dans laquelle on a réalisé une croissance épitaxiale à partir d'une ouverture traversant une structure SOI et atteignant le substrat. Plusieurs zones différentes seront en fait réalisées simultanément et pourront avoir des dimensions distinctes. En outre, en même temps que l'on creuse les tranchées d'isolement entourant les régions épitaxiées (étapes des figures 4A à 4C), on pourra creuser simultanément d'autres tranchées d'isolement ayant d'autres fonctions.

## Revendications

1. Procédé de fabrication d'un substrat hybride SOI/massif, comprenant les étapes suivantes :
a) partir d'une plaquette SOI comprenant une couche semiconductrice monocristalline appelée couche SOI (3), sur une couche isolante (2), sur un substrat semiconducteur monocristallin (1) ;
b) déposer sur la couche SOI au moins une couche de masquage (17, 18) et former des ouvertures (20) traversant la couche de masquage, la couche SOI et la couche isolante jusqu'à atteindre le substrat ;
c) faire croître, sans étape préalable de formation d'espaceurs, par une alternance répétée d'étapes d'épitaxie sélective et de gravure partielle un matériau semiconducteur (27), jusqu'au niveau final désiré ; et
d) graver des tranchées d'isolement (42) entourant lesdites ouvertures remplies de matériau semiconducteur, en empiétant vers l'intérieur sur la périphérie des ouvertures.

2. Procédé selon la revendication 1, dans lequel l'étape c) est poursuivie jusqu'à ce que la partie centrale de la surface supérieure du matériau semiconducteur (27) soit au même niveau que la surface supérieure de la couche SOI.

3. Procédé selon la revendication 1 ou 2, dans lequel le matériau semiconducteur du substrat (1) et celui de la couche SOI (3) sont du silicium.

4. Procédé selon l'une quelconque des revendications 1 à 3, dans lequel l'épaisseur de la couche SOI (3) est comprise entre 3 et 10 nm.

5. Procédé selon l'une quelconque des revendications 1 à 4, dans lequel l'épaisseur de la couche isolante (2) est comprise entre 5 et 50 nm.

6. Procédé selon l'une quelconque des revendications 3 à 5, dans lequel, la couche de masquage comprend un empilement d'une couche d'un oxyde de silicium et d'une couche d'un nitrure de silicium.

7. Procédé selon l'une quelconque des revendications 3 à 6, comprenant en outre, entre les étapes a) et b), une étape consistant à former des régions de silicium-germanium dans des portions de la couche SOI.

8. Procédé selon la revendication 7, dans lequel les régions de silicium-germanium sont formées par condensation.
